# EUROPEAN PATENT SPECIFICATION

(11) **EP 4 439 089 B1**
(45) Date of publication and mention of the grant of the patent: **23.09.2026**
(21) Application number: 24159124.7
(22) Date of filing: 22.02.2024
(51) Int. Cl.: G01R 19/165, G01R 31/396

(54) **VOLTAGE MEASUREMENT CIRCUIT BOARD AND ELECTRICITY STORAGE SYSTEM**
SPANNUNGSMESSLEITERPLATTE UND STROMSPEICHERSYSTEM
CARTE DE CIRCUIT IMPRIMÉ DE MESURE DE TENSION ET SYSTÈME DE STOCKAGE D'ÉLECTRICITÉ

(30) Priority: 27.03.2023 JP 2023050051
(43) Date of publication of application: 02.10.2024
(73) Proprietor: Prime Planet Energy & Solutions, Inc., Tokyo 103-0022 (JP)
(72) Inventor: NAKAYAMA, Masato, Tokyo, 103-0022 (JP)
(74) Representative: Kuhnen & Wacker Patent- und Rechtsanwaltsbüro PartG mbB

(56) References cited:
- WO-A1-2022/186373
- US-A1- 2014 272 497
- US-A1- 2016 169 976
- US-A1- 2021 223 322

## Description

The present disclosure relates to a voltage measurement circuit board and an electricity storage system.

### BACKGROUND

JP 2010-80135 A discloses a battery system for vehicles, which is equipped with a battery block and a battery status detection circuit for detecting the status of each of the batteries constituting the battery block. The electronic components that implement the battery status detection circuit are fixed on one side of a circuit board. The circuit board is disposed facing a terminal surface of the battery block. The electronic components are disposed on a surface opposite the terminal surface. The positive and negative electrode terminals of each of the battery cells are connected to the battery status detection circuit via the circuit board. It is stated that such a battery system is able to detect the voltages of the batteries with high accuracy.

Further, patent document US 2014/272497 A1 discloses a battery assembly including a first module having a first plurality of cells and a first voltage measurement device. The battery module includes a sense wire, coupled to a voltage measurement input of the first voltage measurement device and resistively coupled to a terminal of the first plurality of cells. The battery assembly includes a second module having a second plurality of cells and being configured to couple to the first module with the terminal of the first plurality of cells coupling to a terminal of the second plurality of cells via a **connector** and with the sense wire coupling to the terminal of the second plurality of cells via the connector.

### SUMMARY

There are a variety of cell module configurations depending on the intended use, required electric power, and the like. It is an object of the present invention to provide a highly versatile voltage measurement circuit board and an electricity storage system having the same.

The above object is solved by the subject-matters according to the independent claims. Further advantageous configurations of the invention can be drawn from the dependent claims.

According to an explanatory aspect of the present disclosure, a voltage measurement circuit board includes a predetermined m number of voltage measuring units. Each of the m number of voltage measuring units includes an (N + 1) number of connection ports disposed in sequence for a predetermined N number of series connected cells, a plurality of voltage measurement wires extending respectively from the (N + 1) number of connection ports, and a voltage measurer, connected to a pair of voltage measurement wires extending from adjacent connection ports of the (N + 1) number of connection ports, for measuring a voltage between the adjacent connection ports. At least one of the m number of voltage measuring units includes a branch wire branched from at least one of the plurality of voltage measurement wires, and a branch connection port connected to the branch wire. In the foregoing, m is an integer greater than or equal to 1, and N is an integer greater than or equal to 2.

Such a voltage measurement circuit board is able to measure voltages of various types of cell modules and is therefore highly versatile.

### BRIEF DESCRIPTION OF THE DRAWINGS

Fig. 1 is a schematic view of a voltage measurement circuit board 20A.
Fig. 2 is a schematic view illustrating an example of use of the voltage measurement circuit board 20A.
Fig. 3 is a schematic view illustrating another example of use of the voltage measurement circuit board 20A.
Fig. 4 is a schematic view illustrating an electricity storage system 1.
Fig. 5 is a schematic view illustrating an electricity storage system 2.
Fig. 6 is a schematic view illustrating an electricity storage system 3.
Fig. 7 is a schematic view illustrating an electricity storage system 4.

### DETAILED DESCRIPTION

Hereinbelow, embodiments of the technology according to the present disclosure will be described with reference to the drawings. It should be noted, however, that the disclosed embodiments are, of course, not intended to limit the disclosure. The drawings are depicted schematically and do not necessarily accurately depict actual objects. The features and components that exhibit the same effects are designated by the same reference symbols as appropriate, and the description thereof will not be repeated as appropriate.

The present inventor are considering monitoring of cell voltages through a voltage measurement circuit board for measuring the cell voltages of a plurality of cell modules.

Herein, the term "cell" refers to a device that is the smallest unit of a repeatedly rechargeable electricity storage device. The term "cell module" refers to a component that is composed of a plurality of cells combined together to have a collective function as an electricity storage device. Herein, the term "electricity storage device" refers to a repeatedly chargeable device, and it is intended to encompass what is called storage batteries (chemical cells), such as lithium-ion secondary batteries, nickel-metal hydride batteries, and nickel-cadmium batteries, as well as capacitors (i.e., physical cells) such as electric double-layer capacitors.

### Voltage Measurement Circuit Board

The voltage measurement circuit board proposed herein is a circuit board for monitoring a cell voltage of a plurality cell modules.

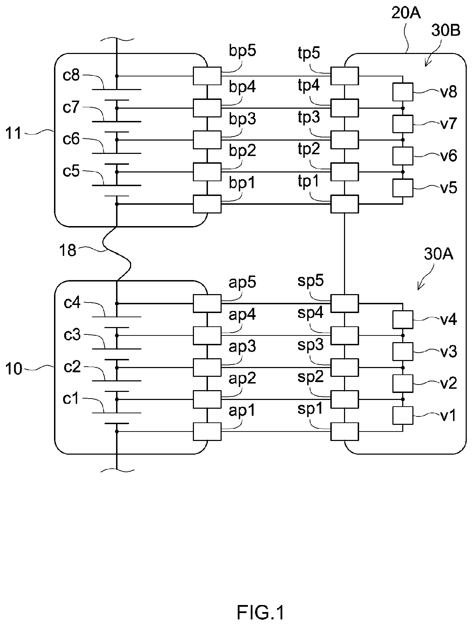

Fig. 1 is a schematic view of a voltage measurement circuit board 20A. Fig. 1 illustrates an example of the voltage measurement circuit board that is under study by the present inventor. For convenience in illustration of the structure of the voltage measurement circuit board, Fig. 1 illustrates a voltage measurement circuit board to which two cell modules 10 and 11 are connected. In Fig. 1, the two cell modules 10 and 11 each include 4 cells c1 to c4 and c5 to c8, respectively. It should be noted that, although cell modules each incorporating 4 cells are illustrated for simplicity in illustration, the number of cells contained in each of the cell modules is not limited to 4. Each of the cell modules may include a greater number of cells, such as 8 or 10.

As illustrated in Fig. 1, the cells c1 to c4 of the cell module 10 and the cells c5 to c8 of the cell module 11 are connected in series sequentially. The two cell modules 10 and 11 are connected in series through a bus bar 18. The cell module 10 is provided with five connection ports ap1 to ap5 for acquiring the potentials at both ends of the cells c1 to c4 and the potentials between the cells so that the cell voltage of each of the cells c1 to c4 can be acquired. Likewise, the cell module 11 is provided with five connection ports bp1 to bp5 for acquiring the potentials at both ends of the cells c5 to c8 and the potentials between the cells. In order to prevent a voltage decrease due to the resistance of the bus bar 18, the connection port ap5 and the connection port bp1 are disposed before and after the bus bar 18.

The voltage measurement circuit board 20A includes cell modules 10 and 11 and corresponding voltage measuring units 30A and 30B, respectively. The voltage measuring unit 30A includes five connection ports sp1 to sp5 corresponding to the connection ports ap1 to ap5. The voltage measuring unit 30A includes four voltage measurers v1 to v4 for acquiring the cell voltage of each of the cells c1 to c4 of the cell module 10. The voltage measuring unit 30B includes five connection ports tp1 to tp5 corresponding to the connection ports bp1 to bp5 of the cell module 11. The voltage measuring unit 30B includes four voltage measurers v5 to v8 for acquiring the cell voltage of each of the cells c5 to c8 of the cell module 11.

In this voltage measurement circuit board 20A, as illustrated in Fig. 1, the five connection ports ap1 to ap5 of the cell module 10 and the five connection ports bp1 to bp5 of the cell module 11 may be connected to 10 connection ports sp1 to sp5 and tp1 to tp5 of the voltage measuring units 30A and 30B in such an order as to be connected in series. This makes it possible to acquire the cell voltage of each of the cells c1 to c8 of the cell modules 10 and 11.

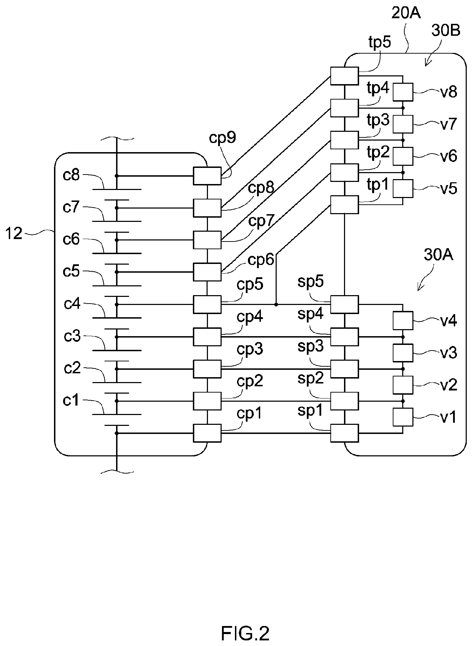

The number of cells that are incorporated in one cell module may vary from one product to another. Fig. 2 is a schematic view illustrating an example of use of the voltage measurement circuit board 20A. Fig. 2 shows an example of use of the voltage measurement circuit board 20A for the case in which eight cells c1 to c8 are incorporated in a cell module 12. In this case, as illustrated in Fig. 2, the cell module 12 incorporates the eight cells c1 to c8 that are connected in series. The voltage measurement circuit board 20A includes eight voltage measurers v1 to v8. Therefore, the voltage measurement circuit board 20A can be used for the purpose of measuring the cell voltages of the eight cells c1 to c8 of such a cell module 12. In this case, the cell module 12 is provided with nine connection ports cp1 to cp9 to acquire the potentials at both ends of the cells c1 to c8 and the potentials between the cells. On the other hand, the voltage measurement circuit board 20A is provided with 10 connection ports sp1 to sp5 and tp1 to tp5, so the wiring connections cannot be made simply. Accordingly, as illustrated in Fig. 2, it may seem possible that a connecting wire is branched from the connection port cp5 that is for acquiring the potential between the cells c4 and c5 and is wired to the connection ports sp5 and tp1 of the voltage measurement circuit board 20A. In this case, complicated wiring work is required because a branch portion from which the connecting wire is branched needs to be formed. Moreover, problems in connection may arise, such that there is a risk of a wire break at the branch portion.

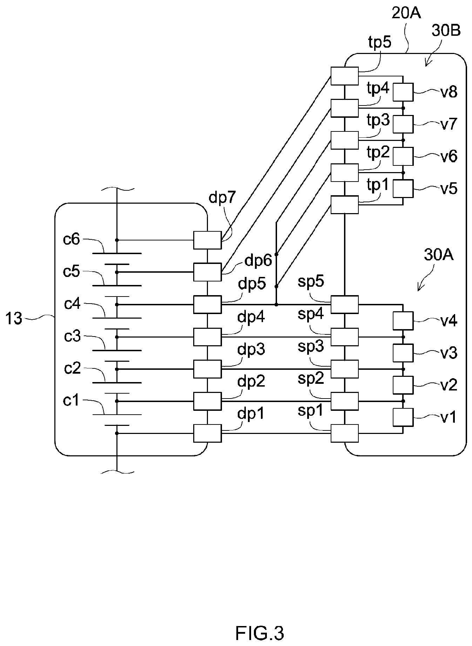

Fig. 3 is a schematic view illustrating another example of use of the voltage measurement circuit board 20A. Fig. 3 shows an example of use of the voltage measurement circuit board 20A for the case in which six cells c1 to c6 are incorporated in a cell module 13. In this case, as illustrated in Fig. 3, the cell module 13 incorporates the six cells c1 to c6 that are connected in series. The cell module 13 is provided with seven connection ports dp1 to dp7 for acquiring the potentials at both ends of the cells c1 to c6 and the potentials between the cells so that the cell voltage of each of the cells c1 to c6 can be acquired. The voltage measurement circuit board 20A includes eight voltage measurers v1 to v8. This means that the voltage measurers v1 to v8 are excessive for the cells c1 to c6 contained in the cell module 13. Herein, the voltage measurers v1 to v4, v7, and v8 are used to measure the voltages of the cells c1 to c6. The voltage measurers v5 and v6 are not used to measure the voltages of the cells c1 to c6. The connection ports tp1 to tp3, which are connected to the voltage measurers v5 and v6 that are not used to measure the voltages, are not brought into an open state from the viewpoint of stabilizing the voltage signals that are input to the voltage measurement circuit board 20A. Herein, a connecting wire is branched from the connection port dp5 and is wired to the connection ports sp5 and tp1 to tp3. In this case as well, complicated wiring work is required because a branch portion from which the connecting wire is branched needs to be formed. Moreover, problems in connection may arise, such that there is a risk of a wire break at the branch portion.

Hereinafter, a voltage measurement circuit board 20 according to the present disclosure is described, together with an electricity storage system 1 including the voltage measurement circuit board 20.

### Electricity Storage System 1

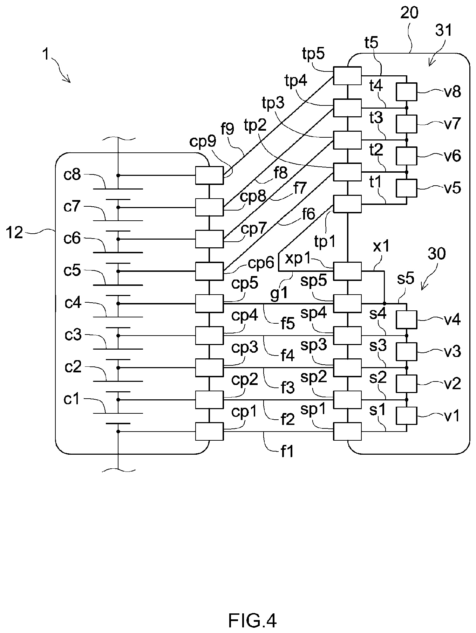

Fig. 4 is a schematic view illustrating the electricity storage system 1. As illustrated in Fig. 4, the electricity storage system 1 includes a cell module 12, a voltage measurement circuit board 20, connecting wires f1 to f9, and a circuit board connecting wire g1. In the cell module 12, eight cells c1 to c8 are connected in series. Other than the plurality of cells c1 to c8 connected in series, the cell module 12 may also include a cell connected in parallel to one or a plurality of cells. The connecting wires f1 to f9 are wires connecting the cell module 12 and the voltage measurement circuit board 20 to each other.

### Voltage Measurement Circuit Board 20

The voltage measurement circuit board includes two voltage measuring units 30 and 31. The voltage measurement circuit board 20 measures the cell voltage of each of the eight cells c1 to c8 contained in the cell module 12. The number of voltage measuring units is not limited to 2 but may be predetermined depending on the number of cell modules, the number of cells, or the like. The voltage measuring units 30 and 31 are configured to be able to measure the cell voltage of the cell modules in each of which four cells are connected in series (for example, the cell modules 10 and 11 shown in Fig. 1).

### Voltage Measuring Units 30 and 31

The voltage measuring unit 30 includes connection ports sp1 to sp5, voltage measurement wires s1 to s5, and voltage measurers v1 to v4. Likewise, the voltage measuring unit 31 includes connection ports tp1 to tp5, voltage measurement wires t1 to t5, and voltage measurers v5 to v8. The voltage measurers v1 to v8 measure the voltages between adjacent connection ports. The voltage measurers v1 to v8 each may be implemented by a voltage measurement circuit including a voltage sensor.

The voltage measuring units 30 and 31 are provided with one more connection ports sp1 to sp5 and tp1 to tp5, respectively, than a predetermined number of series connected cells (4 in this embodiment). The connection ports sp1 to sp5 and tp1 to tp5 are disposed in sequence correspondingly for the cells c1 to c8 connected in series.

The voltage measurement wires s1 to s5 and tp1 to tp5 extend respectively from the connection ports sp1 to sp5 and tp1 to tp5. The voltage measurers v1 to v4 are connected respectively to adjacent pairs of voltage measurement wires among the voltage measurement wires s1 to s5. Likewise, the voltage measurers v5 to v8 are connected respectively to adjacent pairs of voltage measurement wires among the voltage measurement wires t1 to t5.

In this embodiment, the voltage measuring unit 30 of the voltage measuring units 30 and 31 includes a branch wire x1 and a branch connection port xp1 connected to the branch wire x1. The branch wire x1 is branched from the voltage measurement wire s5 of the voltage measurement wires s1 to s5. The voltage measurers v1 to v4 of the voltage measuring unit 30 and the voltage measurers v5 to v8 of the voltage measuring unit 31 are each configured to measure one cell voltage.

Thus, in order to measure the voltages of the cell modules each including two or more cells connected in series, the voltage measuring units may be provided in a number corresponding to the number of cell modules. Each of the voltage measuring units may include voltage measurers in a number corresponding to the number of series connected cells contained in the cell module. Thus, the voltage measurement circuit board may be designed according to the number of cell modules that are to be measured and the number of cells contained in the cell modules.

In this embodiment, the cell module 12 includes eight cells c1 to c8 that are connected in series. The connecting wires f1 to f9 extend from the positive electrode side and the negative electrode side of each of the cells c1 to c8. The connecting wires f1 to f9 are connected respectively to nine connection ports cp1 to cp9 of the cell module 12.

The voltage measuring units 30 and 31 of the voltage measurement circuit board 20 are provided with 10 connection ports sp1 to sp5 and tp1 to tp5. This means that, for the connection ports cp1 to cp9 of the cell module 12, the connection ports sp1 to sp5 and tp1 to tp5 of the voltage measurement circuit board 20 include one extra connection port.

In this embodiment, the connecting wires f1 to f9 are respectively connected to the connection ports sp1 to sp5 and tp2 to tp5 of the voltage measurement circuit board 20. The voltage measurers v1 to v4 measure the cell voltages of the cells c1 to c4. The voltage measurers v6 to v8 measure the cell voltages of the cells c6 to c8. The connection port tp1 is connected to the branch connection port xp1 through the circuit board connecting wire g1. Thus, the circuit board connecting wire g1 connects the branch connection port xp1 with the connection port tp1 that is not connected to any of the connecting wires f1 to f9, among the connection ports sp1 to sp5 and tp1 to tp5. Therefore, the potential of the negative electrode side connection port tp1 of the voltage measurer v5 becomes equal to the potential of the positive electrode side connection port sp5 of the voltage measurer v4. This enables the voltage measurer v5 to measure the voltage of the cell c5.

In the above-described embodiment, the voltage measurement circuit board 20 includes two voltage measuring units 30 and 31, as illustrated in Fig. 4. The two voltage measuring units 30 and 31 include five connection ports sp1 to sp5 and five connection ports tp1 to tp5, five voltage measurement wires s1 to s5 and five voltage measurement wires t1 to t5, and voltage measurers v1 to v4 and v5 to v8, respectively. The five connection ports sp1 to sp5 and the five connection ports tp1 to tp5 are each disposed in sequence correspondingly for four series connected cells. The five voltage measurement wires s1 to s5 and the five voltage measurement wires tp1 to tp5 extend respectively from the five connection ports sp1 to sp5 and the five connection ports tp1 to tp5. Each of the voltage measurers v1 to v4 and v5 to v8 is connected to an adjacent pair of voltage measurement wires that extend from adjacent connection ports of the five connection ports. Each of the voltage measurers v1 to v4 and v5 to v8 measures the voltage between the adjacent connection ports. Among the two voltage measuring units 30 and 31, one voltage measuring unit 30 includes a branch wire x1 branched from one voltage measurement wire s5 of the five voltage measurement wires s1 to s5, and a branch connection port xp1 connected to the branch wire x1.

Because of similar wiring to the embodiment shown in Fig. 1, such voltage measurement circuit board 20 is able to measure the voltage of each of the cells in the two cell modules 10 and 11 (see Fig. 1), which include four cells c1 to c4 and four cells c5 to c8, respectively. In addition, the voltage measurement circuit board 20 may be applicable to cell modules with different configurations. As illustrated in Fig. 4, the cell module 12 includes eight cells c1 to c8 connected in series. For such a cell module 12 as well, it is possible to measure the voltage of each of the cells without necessitating wiring connection processes on the connecting wires. As described above, the voltage measurement circuit board 20 can deal with a plurality of cell module configurations, such as the cell modules 10 and 11 (see Fig. 1) and the cell module 12 (see Fig. 4), and is therefore highly versatile. Moreover, because the circuit board connecting wire g1 can be easily attached to and detached from the connection port tp1 and the branch connection port xp1, it is possible to reduce the trouble involved in processing. Furthermore, because the branch wire is branched within the voltage measurement circuit board, reliability of connections is higher than in cases where the wiring connection processes are made on the connecting wires, so the voltage measurers v1 to v8 can be allowed to detect the cell voltages more stably.

In addition, the above-described electricity storage system 1 includes the cell module 12 including the eight cells c1 to c8, the voltage measurement circuit board 20, the plurality of connecting wires f1 to f9 connecting the cell module 12 and the voltage measurement circuit board 20 together, and the circuit board connecting wire g1. The plurality of connecting wires f1 to f9 extend from the positive electrode side and the negative electrode side of each of the cells c1 to c8. The plurality of connecting wires f1 to f9 are connected to connection ports sp1 to sp5 and tp2 to tp5 among the connection ports sp1 to sp5 and tp1 to tp5. The circuit board connecting wire g1 connects the branch connection port xp1 with the connection port tp1 that is not connected to any of the connecting wires f1 to f9, among the connection ports sp1 to sp5 and tp1 to tp5. In such an electricity storage system 1, the circuit board connecting wire g1 is branched within the above-described voltage measurement circuit board 20. Therefore, wiring connection processes are unnecessary on the connecting wires f1 to f9, the electricity storage system 1 may improve long-term reliability.

It should be noted that the voltage measurement circuit board according to the present disclosure is not limited to the above-described voltage measurement circuit board 20, and various modifications are possible. The configuration of the voltage measurement circuit board may be set as appropriate according to the number of cell modules that are to be measured, the number of cells contained in the cell modules, and the like. The voltage measurement circuit board disclosed herein is applicable to the cases where the number of cell modules that are to be measured (i.e., the number of voltage measuring units) is greater than or equal to 1. The voltage measurement circuit board disclosed herein is applicable to the cases where the number of series connected cells is greater than or equal to 2. The number and the way of branching of branch wire and branch connection port are not limited to the embodiments described above. Hereinbelow, voltage measurement circuit board, 21, 22, and 23 according to other embodiments will be described.

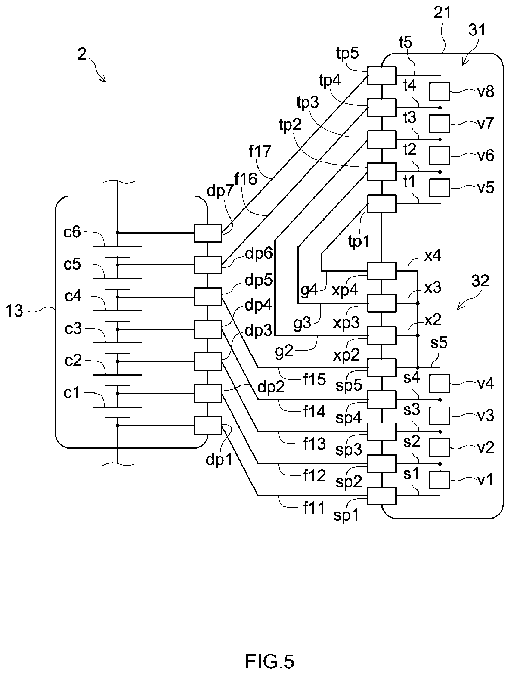

Fig. 5 is a schematic view illustrating an electricity storage system 2. As illustrated in Fig. 5, the electricity storage system 2 includes a cell module 13 and a voltage measurement circuit board 21. The voltage measurement circuit board 21 includes two voltage measuring units 31 and 32. The voltage measuring unit 31 has the same configuration as the voltage measuring unit 31 shown in Fig. 4. Like the voltage measuring unit 30 (see Fig. 4), the voltage measuring unit 32 includes five connection ports sp1 to sp5, five voltage measurement wires s1 to s5, and voltage measurers v1 to v4. The voltage measuring unit 32 includes branch wires x2 to x4, and branch connection ports xp2 to xp4 connected respectively to the branch wires x2 to x4. The branch wires x2 to x4 are branched from the voltage measurement wire s5. The voltage measurement circuit board 21 and the cell module 13 are connected through the connecting wires f11 to f17.

**In** this embodiment, the cell module 13 includes six cells c1 to c6 that are connected in series. The connecting wires f1 to f11 extend from the positive electrode side and the negative electrode side of each of the cells c1 to c6. The connecting wires f1 to f17 are connected respectively to seven connection ports dp1 to dp7 of the cell module 13. The voltage measurers v1 to v4 measure the cell voltages of the cells c1 to c4. The voltage measurer v8 measures the cell voltage of the cell c6.

The voltage measuring units 31 and 32 of the voltage measurement circuit board 21 are provided with 10 connection ports sp1 to sp5 and tp1 to tp5. This means that, for the connection ports dp1 to dp7 of the cell module 13, the connection ports sp1 to sp5 and tp1 to tp5 of the voltage measurement circuit board 21 include three extra connection ports.

**In** this embodiment, the connecting wires f11 to f17 are respectively connected to the connection ports sp1 to sp5, tp4, and tp5 of the voltage measurement circuit board 21. The connection port tp1 is connected to the branch connection port xp4 through the circuit board connecting wire g4. The connection port tp2 is connected to the branch connection port xp3 through the circuit board connecting wire g3. The connection port tp3 is connected to the branch connection port xp2 through the circuit board connecting wire g2. Thus, the circuit board connecting wires g2 to g4 respectively connect the branch connection port xp2 to xp4 with the connection ports tp1 to tp3 that are not connected to any of the connecting wires f11 to f17, among the connection ports sp1 to sp5 and tp1 to tp5. The potential of the negative electrode side connection port tp1 of the voltage measurer v5 to the positive electrode side connection port tp3 of the voltage measurer v6 becomes equal to the potential of the positive electrode side connection port sp5 of the voltage measurer v4. This means that the voltage measurer v7 measures the voltage of the cell c5. The voltage measurers v5 and v6 are not used to measure cell voltages. The connection ports tp1 to tp3, which are connected to the voltage measurers v5 and v6 that are not used to measure cell voltages, are not brought into an open state. This serves to stabilize the signals that are input to the voltage measurement circuit board 21.

In the above-described embodiment, the voltage measuring unit 32 of the two voltage measuring units 31 and 32 includes the branch wires x2 to x4 and the branch connection ports xp2 to xp4 connected to the branch wires x2 to x4. When the voltage measuring unit is provided with a plurality of branch wires and a plurality of branch connection ports as described above, it is allowed to have more options in selecting the configuration of the cell modules to be measured. For example, the voltage measurement circuit board 21 is able to measure the cell voltages for cell modules having seven cells or eight cells, in addition to the cell module 13 having six cells c1 to c6 as illustrated in Fig. 5. Each time the number of cells to be measured increases by one, one of the branch wires x2 to x4 may be detached and the connection port of the cell may be connected to the connection port from which the branch wire is detached. As described above, even when the number of cells to be measured changes, the voltage measurement circuit board 21 is able to easily change connection points by changing the wiring connections of the branch connection ports xp2 to xp4, without making wiring connection processes or without cutting the connecting wires that have been connected.

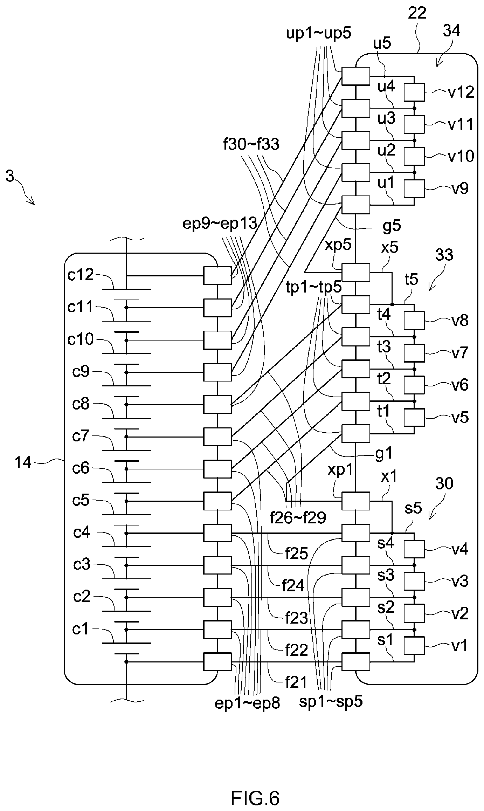

Fig. 6 is a schematic view illustrating an electricity storage system 3. As illustrated in Fig. 6, the electricity storage system 3 includes a cell module 14 and a voltage measurement circuit board 22. The voltage measurement circuit board 22 includes voltage measuring units 30, 33, and 34. The voltage measuring unit 30 has the same configuration as the voltage measuring unit 30 shown in Fig. 4. Like the voltage measuring unit 30, the voltage measuring units 33 and 34 include five connection ports tp1 to tp5 and five connection ports up1 to up5, five voltage measurement wires t1 to t5 and five voltage measurement wires u1 to u5, and voltage measurers v5 to v8 and v9 to v12. The voltage measuring unit 30 includes a branch wire x1 and a branch connection port xp1 connected to the branch wire x1. The branch wire x1 is branched from the voltage measurement wire s5. The voltage measuring unit 33 includes a branch wire x5 and a branch connection port xp5 connected to the branch wire x5. The branch wire x5 is branched from the voltage measurement wire t5. The voltage measurement circuit board 22 and the cell module 14 are connected through the connecting wires f21 to f33.

In this embodiment, the cell module 14 includes 12 cells c1 to c12 that are connected in series. The connecting wires f21 to f33 extend from the positive electrode side and the negative electrode side of each of the cells c1 to c12. The connecting wires f21 to f33 are connected respectively to 13 connection ports ep1 to ep13 of the cell module 14. The voltage measurers v1 to v4 measure the cell voltages of the cells c1 to c4. The voltage measurers v6 to v8 measure the cell voltages of the cells c6 to c8. The voltage measurers v10 to v12 measure the cell voltages of the cells c10 to c12.

The voltage measuring units 30, 33, and 34 of the voltage measurement circuit board 22 are provided with 15 connection ports sp1 to sp5, tp1 to tp5, and up1 to up5. This means that, for the connection ports ep1 to ep13 of the cell module 14, the connection ports sp1 to sp5, tp1 to tp5, and up1 to up5 of the voltage measurement circuit board 22 include two extra connection ports.

In this embodiment, the connecting wires f21 to f33 are respectively connected to the connection ports sp1 to sp5, tp2 to tp5, and up2 to up5 of the voltage measurement circuit board 22. The connection port tp1 is connected to the branch connection port xp1 through the circuit board connecting wire g1. The connection port up1 is connected to the branch connection port xp5 through the circuit board connecting wire g5. Thus, the circuit board connecting wires g1 and g5 connect the branch connection ports xp1 and x5 with the connection ports tp1 and up1 that are not connected to any of the connecting wires f21 to f33, among the connection ports sp1 to sp5, tp1 to tp5, and up1 to up5. Therefore, the potential of the negative electrode side connection port tp1 of the voltage measurer v5 becomes equal to the potential of the positive electrode side connection port sp5 of the voltage measurer v4. This enables the voltage measurer v5 to measure the voltage of the cell c5. The potential of the negative electrode side connection port up1 of the voltage measurer v9 becomes equal to the potential of the positive electrode side connection port tp5 of the voltage measurer v8. This enables the voltage measurer v9 to measure the voltage of the cell c9.

In the above-described embodiment, two voltage measuring units 30 and 33 of the three voltage measuring units 30, 33, and 34 include the branch wires x1 and x5 and the branch connection ports xp1 and xp5 connected to the branch wires x1 and x5, respectively. Because a plurality of voltage measuring units are provided with branch wires and branch connection ports, more freedom is provided in wiring of branch wires. As a result, this embodiment can deal with various types of cell module configurations and may improve the versatility of the voltage measurement circuit board.

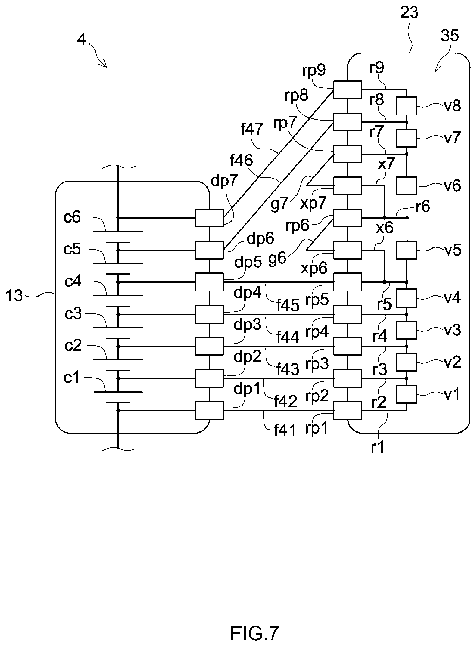

The voltage measurement circuit board disclosed herein is not limited to the embodiments in which a plurality of voltage measuring units are provided. Fig. 7 is a schematic view illustrating an electricity storage system 4. As illustrated in Fig. 7, the electricity storage system 4 includes a cell module 13 and a voltage measurement circuit board 23. The voltage measurement circuit board 23 includes a voltage measuring unit 35. The voltage measuring unit 35 includes nine connection ports rp1 to rp9, voltage measurement wires r1 to r9, and voltage measurers v1 to v8. The voltage measuring unit 35 includes branch wires x6 and x7, and branch connection ports xp6 and xp7 connected respectively to the branch wires x6 to x7. The branch wire x6 is branched from the voltage measurement wire r5. The branch wire x7 is branched from the voltage measurement wire r6. The voltage measurement circuit board 23 and the cell module 13 are connected through the connecting wires f41 to f47.

The cell module 13 has the same configuration as the cell module 13 shown in Fig. 5. The cell module 13 includes six cells c1 to c6 that are connected in series. The connecting wires f41 to f47 extend from the positive electrode side and the negative electrode side of each of the cells c1 to c6. The connecting wires f41 to f47 are connected respectively to 7 connection ports dp1 to dp7 of the cell module 13. The voltage measurers v1 to v4 measure the cell voltages of the cells c1 to c4. The voltage measurer v8 measures the cell voltage of the cell c6.

The voltage measuring unit 35 of the voltage measurement circuit board 23 is provided with nine connection ports rp1 to rp9. This means that, for the connection ports dp1 to dp7 of the cell module 13, the connection ports sp1 to sp5 and tp1 to tp5 of the voltage measurement circuit board 23 include two extra connection ports.

**In** this embodiment, the connecting wires f41 to f47 are respectively connected to the connection ports rp1 to rp5, rp8, and rp9 of the voltage measurement circuit board 23. The connection port rp6 is connected to the branch connection port xp6 through the circuit board connecting wire g6. The connection port rp7 is connected to the branch connection port x7 through the circuit board connecting wire g7. Thus, the circuit board connecting wires g6 and g7 respectively connect the branch connection port xp6 and xp7 with the connection ports rp6 to rp7 that are not connected to any of the connecting wires f41 to f47, among the connection ports rp1 to rp9. Therefore, the potential of the positive electrode side connection ports rp6 and rp7 of the voltage measurers v5 and v6 becomes equal to the potential of the positive electrode side connection port rp5 of the voltage measurer v4. The voltage measurers v5 and v6 are not used to measure cell voltages. The connection ports rp5 to rp7, which are connected to the voltage measurers v5 and v6 that are not used to measure cell voltages, are not brought into an open state. This serves to stabilize the signals that are input to the voltage measurement circuit board 23.

Various embodiments of the technology according to the present disclosure have been described hereinabove. Unless specifically stated otherwise, the embodiments described herein do not limit the scope of the present disclosure. For example, the voltage measurement circuit board may include four or more voltage measuring units. When the voltage measurement circuit board includes a plurality of voltage measuring units, the number of voltage measurers may not be the same as the number of the voltage measuring units. The patterns of arrangement of the branch ports and the branch wires are not limited to the above-described embodiments. The numbers of branch ports and branch wires, and the branching voltage measurement wires may be selected according to the configurations of the cell modules to be measured. It should be noted that various other modifications and alterations may be possible in the embodiments of the technology disclosed herein.

## Claims

1. A voltage measurement circuit board (20) comprising:
a predetermined m number of voltage measuring units (30, 31),
each of the m number of voltage measuring units (30, 31) including:
an [N+1] number of connection ports (sp1 to sp5, tp1 to tp5) disposed in sequence for a predetermined N number of series connected cells;
a plurality of voltage measurement wires (s1 to s5, t1 to t5) extending respectively from the [N+1] number of connection ports (sp1 to sp5, tp1 to tp5); and
a voltage measurer (v1 to v8), connected to a pair of voltage measurement wires (s1 to s5, t1 to t5) extending from adjacent ones of the [N +1] number of connection ports (sp1 to sp5, tp1 to tp5), for measuring a voltage between the adjacent connection ports;
the voltage measurement circuit board (20) is **characterised in that**
at least one voltage measuring unit (30) among the m number of voltage measuring units (30, 31) including:
a plurality of branch wires (x2 to x4) branched from at least one of the plurality of the voltage measurement wires (s1 to s5, t1 to t5); and
a plurality of branch connection ports (xp2 to xp4) connected to the branch wires (x2 to x4),
wherein m is an integer greater than or equal to 1 and N is an integer greater than or equal to 2.

2. The voltage measurement circuit board (20) according to claim 1, wherein m is an integer greater than or equal to 2.

3. An electricity storage system (1) comprising:
a cell module (12) including an L number of cells;
a voltage measurement circuit board (20) according to claim 1 or 2;
a plurality of connecting wires (f1 to f9) connecting the cell module (12) and the voltage measurement circuit board (20); and
a circuit board connecting wire (g1), wherein:
the plurality of connecting wires (f1 to f9) extend from a positive electrode side and a negative electrode side of each of the L number of cells; and
each of the plurality of connecting wires (sp1 to sp5, tp1 to tp5) is connected to a respective one of the connection ports; wherein
the circuit board connecting wire (g1) connects the branch connection port (xp1) with one of the connection ports (tp1) that is not connected to any of the connecting wires (sp1 to sp5, tp1 to tp5).

## Patentansprüche

1. Spannungsmessplatine (20), aufweisend:
eine vorbestimmte Anzahl m von Spannungsmesseinheiten (30, 31),
wobei jede der m Spannungsmesseinheiten (30, 31) umfasst:
eine Anzahl [N + 1] von Anschlussports (sp1 bis sp5, tp1 bis tp5), die nacheinander für eine vorbestimmte Anzahl N von in Reihe geschalteten Zellen angeordnet sind;
eine Mehrzahl von Spannungsmessdrähten (s1 bis s5, t1 bis t5), die sich entsprechend von der [N + 1] Anzahl von Anschlussports (sp1 bis sp5, tp1 bis tp5) erstrecken; und
einen Spannungsmesser (v1 bis v8), der mit einem Paar von Spannungsmessdrähten (s1 bis s5, t1 bis t5) verbunden ist, die sich von benachbarten der [N + 1] Anschlussports (sp1 bis sp5, tp1 bis tp5) erstrecken, um eine Spannung zwischen den benachbarten Anschlussports zu messen;
wobei die Spannungsmessplatine (20) **dadurch gekennzeichnet ist, dass**
zumindest eine Spannungsmesseinheit (30) aus den m Spannungsmesseinheiten (30, 31) umfasst:
eine Mehrzahl von Abzweigungsdrähten (x2 bis x4), die von zumindest einem der Mehrzahl von Spannungsmessdrähten (s1 bis s5, t1 bis t5) abgezweigt sind; und
eine Mehrzahl von Abzweigungs-Anschlussports (xp2 bis xp4), die mit den Abzweigungsdrähten (x2 bis x4) verbunden sind,
wobei m eine ganze Zahl größer oder gleich 1 ist, und N eine ganze Zahl größer oder gleich 2 ist.

2. Spannungsmessplatine (20) nach Anspruch 1, wobei m eine ganze Zahl größer oder gleich 2 ist.

3. Stromspeichersystem (1), aufweisend:
ein Zellmodul (12) mit einer Anzahl L von Zellen;
eine Spannungsmessplatine (20) nach Anspruch 1 oder 2;
eine Mehrzahl von Verbindungsdrähten (f1 bis f9), die das Zellmodul (12) und die Spannungsmessplatine (20) verbinden; und
einen Platinen-Verbindungsdraht (g1), wobei:
sich die Mehrzahl von Verbindungsdrähten (f1 bis f9) von einer positiven Elektrodenseite und einer negativen Elektrodenseite jeder der L Zellen erstreckt; und
jeder der Mehrzahl von Verbindungsdrähten (sp1 bis sp5, tp1 bis tp5) mit einem entsprechenden der Anschlussports verbunden ist; wobei
der Platinen-Verbindungsdraht (g1) den Abzweigungs-Anschlussport (xp1) mit einem der Anschlussports (tp1) verbindet, der nicht mit einem der Verbindungsdrähte (sp1 bis sp5, tp1 bis tp5) verbunden ist.

## Revendications

1. Un circuit imprimé de mesure de tension (20) comprenant :
un nombre prédéterminé m d'unités de mesure de tension (30, 31),
chacune des m unités de mesure de tension (30, 31) comprenant :
un nombre [N + 1] de ports de connexion (sp1 à sp5, tp1 à tp5) disposés en séquence pour un nombre prédéterminé N de cellules connectées en série ;
une pluralité de fils de mesure de tension (s1 à s5, t1 à t5) partant respectivement des [N + 1] ports de connexion (sp1 à sp5, tp1 à tp5) ; et
un dispositif de mesure de tension (v1 à v8), connecté à une paire de fils de mesure de tension (s1 à s5, t1 à t5) partant de ports de connexion adjacents parmi les [N + 1] ports de connexion (sp1 à sp5, tp1 à tp5), pour mesurer une tension entre les ports de connexion adjacents ; le circuit imprimé de mesure de tension (20) est **caractérisé en ce que**
au moins une unité de mesure de tension (30) parmi les m unités de mesure de tension (30, 31) comprend :
une pluralité de fils de dérivation (x2 à x4) dérivés d'au moins l'un de la pluralité de fils de mesure de tension (s1 à s5, t1 à t5) ; et
une pluralité de bornes de connexion de dérivation (xp2 à xp4) reliées aux fils de dérivation (x2 à x4),
où m est un nombre entier supérieur ou égal à 1 et N est un nombre entier supérieur ou égal à 2.

2. Le circuit imprimé de mesure de tension (20) selon la revendication 1, dans lequel m est un nombre entier supérieur ou égal à 2.

3. Un système de stockage d'électricité (1) comprenant :
un module de cellules (12) comprenant un nombre L de cellules ;
un circuit imprimé de mesure de tension (20) selon la revendication 1 ou 2 ;
une pluralité de fils de connexion (f1 à f9) reliant le module de cellules (12) et le circuit imprimé de mesure de tension (20) ; et
un fil de connexion de circuit imprimé (g1), dans lequel :
la pluralité de fils de connexion (f1 à f9) s'étend depuis un côté d'électrode positive et un côté d'électrode négative de chacune des L cellules ; et
chacun des fils de connexion (sp1 à sp5, tp1 à tp5) est connecté à l'un des ports de connexion respectifs ; dans lequel
le fil de connexion du circuit imprimé (g1) relie le port de connexion de dérivation (xp1) à l'un des ports de connexion (tp1) qui n'est connecté à aucun des fils de connexion (sp1 à sp5, tp1 à tp5).
